# EUROPÄISCHE PATENTSCHRIFT

(11) **EP 3 891 856 B1**
(45) Veröffentlichungstag und Bekanntmachung des Hinweises auf die Patenterteilung: **27.03.2024**
(21) Anmeldenummer: 18814580.9
(22) Anmeldetag: 04.12.2018
(51) Int. Cl.: H02B 1/21

(54) **SAMMELSCHIENENADAPTER UND UNTERDECKELEMENT FÜR SAMMELSCHIENENADAPTER**
BUSBAR ADAPTER AND LOWER DECK ELEMENT FOR A BUSBAR ADAPTER
ADAPTATEUR POUR JEU DE BARRES ET ÉLÉMENT D'ÉTAGE INFÉRIEUR POUR ADAPTATEUR DE RAIL COLLECTEUR

(43) Veröffentlichungstag der Anmeldung: 13.10.2021
(73) Patentinhaber: Klaus Bruchmann GmbH, 4600 Thalheim bei Wels (AT)
(72) Erfinder: BRUCHMANN, Klaus Ewald Karl, 96450 Coburg (DE); BERGER, Thomas, 97640 Oberstreu (DE)
(74) Vertreter: Appelt, Christian W.
(86) Internationale Anmeldenummer: PCT/EP2018/083501
(87) Internationale Veröffentlichungsnummer: WO 2020/114579

(56) Entgegenhaltungen:
- EP-A1- 2 546 856
- EP-A1- 2 911 253
- WO-A1-2014/026702
- WO-A1-2016/142163
- DE-U1- 29 705 224
- DE-U1-202004 019 766

## Beschreibung

Die vorliegende Erfindung bezieht sich auf einen Sammelschienenadapter für einen Anschluss an ein mehrphasiges oder mehrpoliges Sammelschienensystem, insbesondere an ein dreiphasiges Sammelschienensystem mit drei Sammelschienen. Solche Sammelschienenadapter eignen sich insbesondere zur Befestigung und zum Anschluss von elektrischen Geräten, beispielsweise Installationsgeräten, an elektrischen Sammelschienensystemen. Die vorliegende Erfindung bezieht sich ferner auf ein Unterdeckelement für einen Sammelschienenadapter.

Ein solches System ist beispielsweise aus der DE 195 15 923 C2 oder der EP 2 975 708 A1 bekannt.

Ein weiteres System des Standes der Technik ist aus der WO 2014/026702 A1 oder aus der EP 2 911 253 A1 bekannt.

Es ist eine Aufgabe der vorliegenden Erfindung, einen solchen Sammelschienenadapter und ein solches Unterdeckelement im Hinblick auf die Nutzerfreundlichkeit und unter Berücksichtigung der gewünschten Anwendungen weiter zu verbessern.

Diese Aufgabe wird durch ein Unterdeckelement gemäß Anspruch 1 und einen Sammelschienenadapter gemäß Anspruch 2 gelöst. Die Ansprüche 3 bis 12 betreffen besonders vorteilhafte Ausführungsformen eines Sammelschienenadapters gemäß Anspruch 2.

Der Sammelschienenadapter gemäß der vorliegenden Erfindung umfasst ein Gehäuse, wobei das Gehäuse zumindest ein Oberdeckelement und ein Unterdeckelement umfasst. Das Oberdeckelement ist dabei so ausgebildet, dass elektrische Geräte, beispielsweise Installationsgeräte, befestigt werden können, wobei das Unterdeckelement so ausgebildet ist, dass eine elektrische Verbindung mit den Sammelschienen des Sammelschienensystems hergestellt werden kann.

Der Sammelschienenadapter umfasst dabei mindestens zwei Kontaktvorrichtungen, jeweils für einen Anschluss an eine der Sammelschienen des Sammelschienensystems. Wie oben erläutert, betrifft die vorliegende Erfindung insbesondere einen Sammelschienenadapter für ein dreiphasiges Sammelschienensystem, auch dreipoliges Sammelschienensystem genannt, in welchem Falle das Sammelschienensystem drei Sammelschienen aufweist, so dass der Sammelschienenadapter auch drei Kontaktvorrichtungen, jeweils eine Kontaktvorrichtung pro Sammelschiene, umfasst.

Der Sammelschienenadapter umfasst ferner mindestens zwei Kontaktleitungen für eine elektrische Verbindung zu einem elektrischen Gerät, das an dem Sammelschienenadapter, insbesondere am Oberdeckelement, befestigt werden kann, wobei die Kontaktleitung elektrisch an eine Kontaktvorrichtung angeschlossen ist. Die Kontaktvorrichtungen sind dabei an dem oder in dem Unterdeckelement angeordnet.

Bei einem dreiphasigen oder dreipoligen System umfasst der Sammelschienenadapter natürlich drei Kontaktvorrichtungen und drei Kontaktleitungen, so dass eine elektrische Verbindung mit jeder der Sammelschienen hergestellt werden kann.

Gemäß der Erfindung umfasst der Sammelschienenadapter zusätzlich eine Strommessvorrichtung, die so ausgebildet ist, dass in dem Sammelschienenadapter eine Strommessung für jede Phase oder für jeden Pol des Sammelschienenadapters erfolgen kann.

Dies hat den Vorteil, dass bereits im Sammelschienenadapter, an einer zentralen Stelle, also vor den und unabhängig von den angeschlossenen Geräten, eine Strommessung erfolgen kann, insbesondere auch eine Strommessung, die jede einzelne Phase (jeden Pol) berücksichtigt.

Für den Nutzer bzw. Betreiber hat dies den Vorteil, dass er an dieser zentralen Stelle alle relevanten Informationen über das angeschlossene System erhalten kann, insbesondere direkt Rückschlüsse auf den Betrieb des Systems, den Stromverbrauch sowie Änderungen während des Betriebs ziehen kann, die für den Betrieb oder die Überwachung des Systems von Bedeutung sind.

Insbesondere wird dadurch vermieden, dass Strommessvorrichtungen an den einzelnen Geräten, insbesondere Installationsgeräten, vorgesehen sein müssen, so dass ein solcher Sammelschienenadapter eine erhöhte Flexibilität beim Einsatz der elektrischen Geräte ermöglicht, weil grundsätzlich alle Geräte, unabhängig davon, ob sie eine Strommessung erlauben oder nicht, an den Sammelschienenadapter angeschlossen werden können, ohne auf die hilfreichen Informationen im Hinblick auf das Gesamtsystem verzichten zu müssen.

Erfindungsgemäß besteht die Strommessvorrichtung aus mehreren Untereinheiten oder Bauteilen oder Strommessvorrichtungen. Bevorzugt wird pro Phase eine eigene Strommessvorrichtung eingesetzt.

Dabei gibt es besonders vorteilhafte Wege und Möglichkeiten, eine solche Strommessvorrichtung in den Sammelschienenadapter auf besonders bevorzugte Weise, insbesondere besonders platzsparend und effektiv, unterzubringen, worauf nachfolgend eingegangen werden wird.

Erfindungsgemäß sind die Strommessvorrichtungen an oder in dem Unterdeckelement angeordnet. Dies hat insbesondere bei der Herstellung Vorteile, da die Kontaktvorrichtungen typischerweise und bevorzugt ebenfalls im Unterdeckelement vorgesehen sind, so dass von dort die Kontaktleitungen verlaufen und bereits an dieser Stelle die Strommessvorrichtungen vorgesehen werden können. Insbesondere bei einer zweiteiligen Form des Gehäuses mit einem Oberdeckelement und einem Unterdeckelement, oder auch bei mehrteiligen Gehäusen, die beispielsweise ein Zwischendeckelement umfassen, führt dieser Aufbau zu einer Vereinfachung der Gesamtstruktur und führt daher zu einer kostengünstigeren Herstellung und verhindert Fehlbedienungen.

Eine besonders bevorzugte Möglichkeit, eine Strommessvorrichtung zu realisieren, ist das Vorsehen mindestens einer Rogowskispule. Bevorzugt wird als Strommessvorrichtung eine Rogowskispule pro Phase bzw. pro Pol eingesetzt.

Solche Rogowskispulen werden bevorzugt als Bauteile realisiert, die eine Plattenform, bevorzugt eine rechteckige Plattenform, insbesondere eine quadratische Plattenform aufweisen, so dass die Abmessungen sehr gering gehalten werden können. Bevorzugte Rogowskispulen in Form eines solchen Plattenelements sind im Wesentlichen quadratisch ausgebildet, mit einer Plattenstärke von 1 bis 4 Millimetern, beispielsweise 1,6 oder 3,2 Millimetern, und einer Kantenlänge von 10 bis 25 Millimetern, bevorzugt 16 oder 22 Millimetern.

Solche Bauelemente können daher besonders platzsparend in den Sammelschienenadapter, insbesondere das Unterdeckelement eines Sammelschienenadapters, eingebaut werden, so dass insbesondere die Bauhöhe des Sammelschienenadapters nicht vergrößert werden muss.

Gemäß einer Ausführungsform sind die Rogowskispulen oder die Bauteile der Rogowskispulen so in dem Sammelschienenadapter angeordnet und befestigt, dass eine Ebene, in der die Spulenwicklung der Rogowskispulen liegen, senkrecht oder im Wesentlichen senkrecht zu einer Ebene verläuft, die von den Sammelschienen des Sammelschienensystems gebildet wird. Diese Einbaurichtung wird nachfolgend auch als vertikale Richtung bezeichnet.

Wie oben erwähnt, werden solche Rogowskispulen bevorzugt als plattenförmige Bauteile realisiert, wobei die Ebene, in der die Spulenwicklung der Rogowskispulen liegt, der Ebene des plattenförmigen Bauteils entspricht.

In diesem Zusammenhang wird darauf hingewiesen, dass die Ebene, die durch die Sammelschienen des Sammelschienensystems gebildet wird, als x-y-Ebene oder als horizontale Ebene bezeichnet wird, während eine Richtung senkrecht oder normal hierzu als vertikale Richtung, in dieser Anmeldung auch als z-Anmeldung, bezeichnet wird.

Ein Sammelschienenadapter gemäß der Erfindung erstreckt sich über alle Schienen des Sammelschienenadapters in einer Richtung (x-Richtung) parallel zu dieser horizontalen Ebene oder x-y-Ebene und senkrecht zu einer Längserstreckung jeder der Sammelschienen (y-Richtung).

Diese Erstreckung des Sammelschienenadapters quer zu der Längserstreckung der Sammelschienen (y-Richtung) definiert eine Längsrichtung oder Längsachse des Sammelschienenadapters, die in x-Richtung ausgerichtet ist.

An seinen Enden (in Längsrichtung) weist der Sammelschienenadapter und/oder das Unterdeckelement und/oder das Oberdeckelement Stirnflächen auf, die die jeweiligen Elemente in dieser Längsrichtung, entlang der x-Achse, begrenzen.

Gemäß der Erfindung umfasst das Unterdeckelement mindestens zwei Aufnahmetaschen, bevorzugt schlitzförmige Aufnahmetaschen, jeweils für eine Strommessvorrichtung, insbesondere eine Rogowskispule, wobei die Aufnahmetaschen jeweils eine Ebene definieren, die senkrecht oder im Wesentlichen senkrecht zu einer Ebene liegt, die von den Sammelschienen des Sammelschienensystems gebildet wird.

Gemäß der Erfindung umfasst das Unterdeckelelement ferner mindestens zwei Fußelemente zur Befestigung des Sammelschienenadapters an den Sammelschienen, wobei sich jede der Aufnahmetaschen für eine Strommessvorrichtung, insbesondere eine Rogowskispule, zumindest teilweise in ein Fußelement erstreckt.

Dabei werden auf besonders bevorzugte Weise die räumlichen Gegebenheiten eines Sammelschienenadapters genutzt, insbesondere kann die Baugröße und insbesondere die Bauhöhe des Sammelschienenadapters, insbesondere des Unterdeckelements, im Vergleich zu Sammelschienenadaptern, die gar keine Strommessvorrichtung umfassen, unverändert gering bleiben. Darüberhinaus ist es aufgrund der Anschlussgegebenheiten besonders einfach, die Kontaktleitungen des Sammelschienenadapters durch die Rogowskispule bzw. die entsprechenden Bauteile, die eine Durchführöffnung für die Kontaktleitungen umfassen, zu führen. Eine solche Anordnung, die eine vertikale oder im wesentlichen vertikale bzw. eine senkrechte oder im wesentlichen senkrechte Anordnung der Rogowskispulen bzw. der entsprechenden Bauteile in dem Unterdeckelement vorsieht, wobei gleichzeitig Aufnahmetaschen im Unterdeckelement vorgesehen sind, die sich zumindest teilweise in ein Fußelement des Unterdeckelements erstrecken, realisiert daher auf besonders vorteilhafte, kombinatorische Weise sowohl die Vorteile der bevorzugten Anordnung von Strommessvorrichtung und Kontakthaltung im Hinblick auf die Montage und die Genauigkeit der Messungen, während gleichzeitig die Gesamtabmessungen, insbesondere die Bauhöhe, gering gehalten werden kann.

Eine solche Anordnung sorgt auch dafür, dass nicht nur die Bauhöhe, sondern auch die Menge des Baumaterials gering gehalten werden kann, so dass eine kunststoffsparende und damit kostengünstige Flachbauweise erzielt wird.

Bei einer weiteren bevorzugten Ausführungsform umfasst der Sammelschienenadapter auch eine elektronische Auswerteeinheit, die an die Strommessvorrichtungen, insbesondere an die bevorzugten Rogowskielemente angeschlossen werden kann.

Bevorzugt umfasst die elektronische Auswerteeinheit ein Gehäuse, das an einer Stirnfläche des Sammelschienenadapters, insbesondere an einer Stirnfläche des Unterdeckelements des Sammelschienenadapters, befestigt werden kann, wobei das Gehäuse der Auswerteeinheit ein oder mehrere Hakenelemente umfasst, die in zugehörige Öffnungen an einer Stirnfläche des Sammelschienenadapters, insbesondere in zugehörige Öffnungen der Stirnfläche des Unterdecks des Sammelschienenadapters, eingesetzt werden können. Eine solche Realisierung einer elektronischen Auswerteeinheit erhält und unterstützt auf besonders vorteilhafte Weise die oben beschriebene kunststoffsparende und damit kostengünstige Flachbauweise, wobei insbesondere die Auswerteeinheit und das Gehäuse sich nicht über die Bauhöhe des Sammelschienenadapters, bevorzugt nicht einmal über die Bauhöhe des Unterdeckelements des Sammelschienenadapters, hinaus erstrecken.

Eine Befestigung mittels Hakenelementen, die in zugehörige Öffnungen in dem Sammelschienenadapter eingehängt werden können, hat insbesondere den Vorteil, dass einerseits die Montage sehr einfach und damit kostengünstig erfolgen kann, andererseits ist es auch möglich, die Auswerteeinheit relativ einfach zu demontieren, sollte sie zu einem späteren Zeitpunkt oder bei einer bestimmten Anwendung nicht oder nicht mehr gebraucht werden. Auch ein Recycling wird vereinfacht, da einzelne Bauteile schnell und einfach getrennt werden können.

Besonders bevorzugt sind dabei die Hakenelemente und die zugehörigen Öffnungen so ausgebildet, dass die elektronische Auswerteeinheit in das Unterdeckelement eingehängt werden kann, wobei dann durch Aufsetzen des Oberdeckelements die elektronische Auswerteeinheit in ihrer Betriebsposition gehalten und/oder verriegelt wird, so dass keinerlei zusätzliche Halte- oder Verriegelungselemente erforderlich sind.

Gemäß einer weiteren Ausführungsform sind die Kontaktleitungen im Bereich der Rogowskispulen abisoliert. Dies hat insbesondere Vorteile bei Kontaktleitungen mit größeren Leitungsquerschnitten, beispielsweise bei Leitungsquerschnitten von 10 mm² oder 16 mm². Ohne Beeinflussung der Wirksamkeit und bei gleichzeitiger Beibehaltung der galvanischen Trennung, kann damit auch die Gesamtbauhöhe gering gehalten werden.

Bevorzugt ist die Strommessvorrichtung bzw. sind die Strommessvorrichtungen, insbesondere die Rogowskispulen, mittels elektrischer Leitungen mit der elektronischen Auswerteeinheit verbunden, wobei bevorzugt diese Leitungen ebenfalls vollständig innerhalb des Unterdeckelements verlaufen.

Bei einer bevorzugten Ausführungsform umfasst die elektronische Auswerteeinheit auch mindestens eine RJ-Buchse ("Registered Jack-Buchse"), oder ähnliche Anschlussverbindungen, zum Anschluss an eine Bus-Anbindung, um die Auswertungen besonders vorteilhaft zu fahren.

Ferner ist es bei einer anderen bevorzugten Ausführungsform möglich, den Sammelschienenadapter und insbesondere die elektronische Auswerteeinheit mit Vorrichtungen oder Modulen zu versehen, die eine WLAN-Verbindung oder eine Bluetooth- oder eine andere Verbindung zum Datentransfer ermöglichen.

Die Erfindung betrifft ferner ein Unterdeckelement für einen Sammelschienenadapter wie er oben beschrieben worden ist, wobei das Unterdeckelement mindestens zwei Fußelemente zur Befestigung des Unterdeckelements an Sammelschienen umfasst. Wie oben erwähnt, handelt es sich in der Regel um dreiphasige oder dreipolige Systeme, so dass das Unterdeckelement drei Fußelement umfasst.

Ein solches Unterdeckelement umfasst mindestens zwei Aufnahmetaschen, bei einer dreiphasigen oder dreipoligen Ausführung drei Aufnahmetaschen, die bevorzugt schlitzförmig ausgebildet sind und die j eweils eine Strommessvorrichtung, insbesondere die oben genannten Rogowskispulen, aufnehmen können. Diese Aufnahmetaschen verlaufen, wie beschrieben, in einer Ebene, die senkrecht oder im Wesentlichen senkrecht zu einer Ebene verläuft, die von den Sammelschienen gebildet wird, wobei sich jede der Aufnahmetaschen zumindest teilweise in ein Fußelement erstreckt, wie es oben bereits beschrieben worden ist.

Diese und weitere Merkmale und Vorteile der vorliegenden Erfindung werden anhand der nachfolgenden Figuren, die besondere Ausführungsformen zeigen, noch deutlicher.
Fig 1 zeigt eine perspektivische Ansicht eines Sammelschienenadapters gemäß der vorliegenden Erfindung;
Fig. 2 zeigt die in Fig. 1 gezeigte Ausführungsform des erfindungsgemäßen Sammelschienenadapters in einer teilweisen Explosionsdarstellung;
Fig. 3 zeigt die in den Fig. 1 und 2 gezeigten Ausführungsform des Sammelschienenadapters, in der jedoch das Oberdeckelement nicht dargestellt ist;
Fig. 4 zeigt eine Teil-Querschnittsansicht einiger Elemente der in den Fig. 1 bis 3 gezeigten Ausführungsform eines erfindungsgemäßen Sammelschienenadapters;
Fig. 5 zeigt eine perspektivische Ansicht eines Gehäuses einer elektronischen Auswerteeinheit;
Fig. 6 zeigt eine teilweise geschnittene Ansicht eines Teilbereichs eines erfindungsgemäßen Sammelschienenadapters;
Fig. 7 zeigt eine Teil-Querschnittsansicht einiger Elemente einer weiteren Ausführungsform eines erfindungsgemäßen Sammelschienenadapters;
Fig. 8 zeigt eine Draufsicht auf ein Messelement, das mittels einer kapazitiven Kopplung arbeitet und in einer Ausführungsform eingesetzt werden kann, wie sie beispielsweise in Fig. 7 gezeigt ist; und
Fig. 9 zeigt einen Querschnitt durch das in Fig. 8 gezeigte Messelement entlang der Linie B-B.

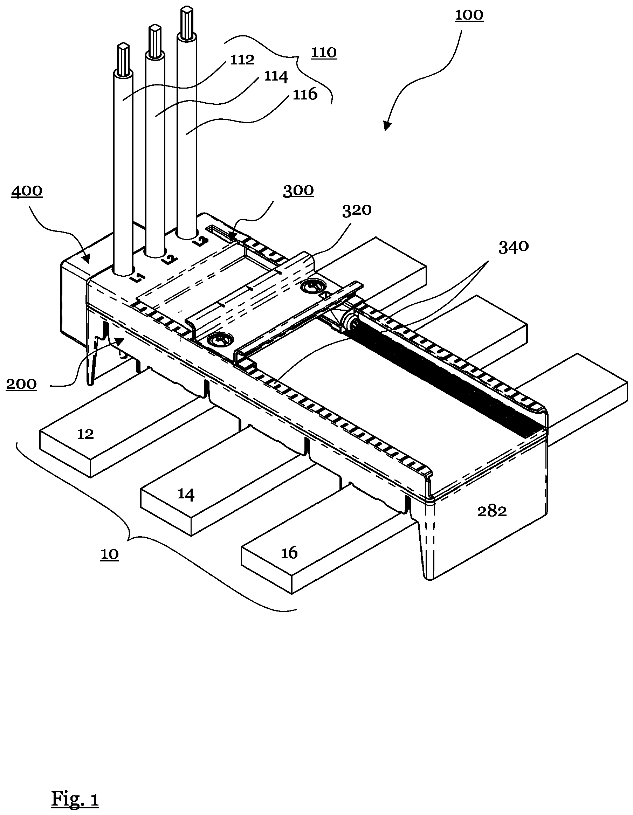

Fig. 1 zeigt eine erste Ausführungsform eines erfindungsgemäßen Sammelschienenadapters 100 zum Anschluss an ein dreipoliges oder dreiphasiges Sammelschienensystem 10, das drei Sammelschienen 12, 14, 16 umfasst, die in Fig. 1 teilweise dargestellt sind.

Der Sammelschienenadapter 100 umfasst ein Unterdeckelement 200 und ein Oberdeckelement 300, die in einer Betriebsposition miteinander verbunden sind, wie es auch in Fig. 1 gezeigt ist.

Das Oberdeckelement 300 umfasst bei dieser Ausführungsform Halte- oder Befestigungsstege 340, auf denen, in verschiedenen Positionen, ein oder mehrere Tragschienen 320 zur Befestigung von elektrischen Geräten befestigt werden können.

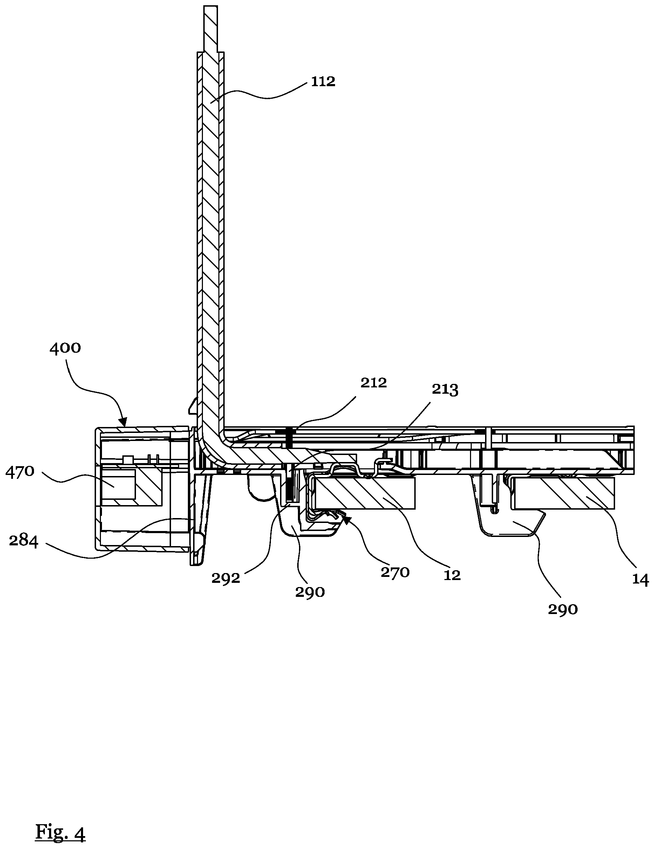

Das Unterdeckelement 200 umfasst insgesamt drei Füße und drei Kontaktvorrichtungen, mittels denen das Unterdeckelement 200 und damit der Sammelschienenadapter 100 an den Sammelschienen 12, 14, 16 befestigt und mit diesen in einen elektrischen Kontakt gebracht werden kann. Die Füße und Kontaktelemente sind in dieser perspektivischen Darstellung schlecht oder nicht zu sehen, werden aber insbesondere in Fig. 4 näher gezeigt.

Das Unterdeckelement hat zwei Stirnflächen, von denen in Fig. 1 aufgrund der perspektivischen Darstellung lediglich eine Stirnfläche, nämlich die Stirnfläche 282, gezeigt ist, während die andere Stirnfläche (284, siehe Fig. 4) gegenüberliegend angeordnet ist, so dass die Sammelschienen 12, 14, 16 zwischen diesen Stirnflächen 282, 284 verlaufen, wenn der Sammelschienenadapter 100 auf dem Sammelschienensystem 10 in seiner Position angeordnet und befestigt ist.

Die in Fig. 1 gezeigte Ausführungsform des Sammelschienenadapters 100 umfasst auch eine elektronische Auswerteeinheit 400, die an einer Stirnseite (284, siehe Fig. 4) des Unterdeckelements 200 angebracht und befestigt ist.

Der Sammelschienenadapter 100 umfasst insgesamt drei Kontaktleitungen 112, 114, 116, gemeinsam mit dem Bezugszeichen 110 bezeichnet, die mit den Kontaktvorrichtungen (270, siehe insbesondere Fig. 4) verbunden sind und die elektrische Verbindung zu einem elektrischen Gerät herstellen, das auf dem Sammelschienenadapter 100 angeordnet und befestigt werden kann, insbesondere auf der Tragschiene 320, die, wie oben beschrieben, in ihrer Position im Wesentlichen in einem Bereich zwischen den beiden Stirnseiten (282, 284, siehe Fig. 4) verstellbar ist.

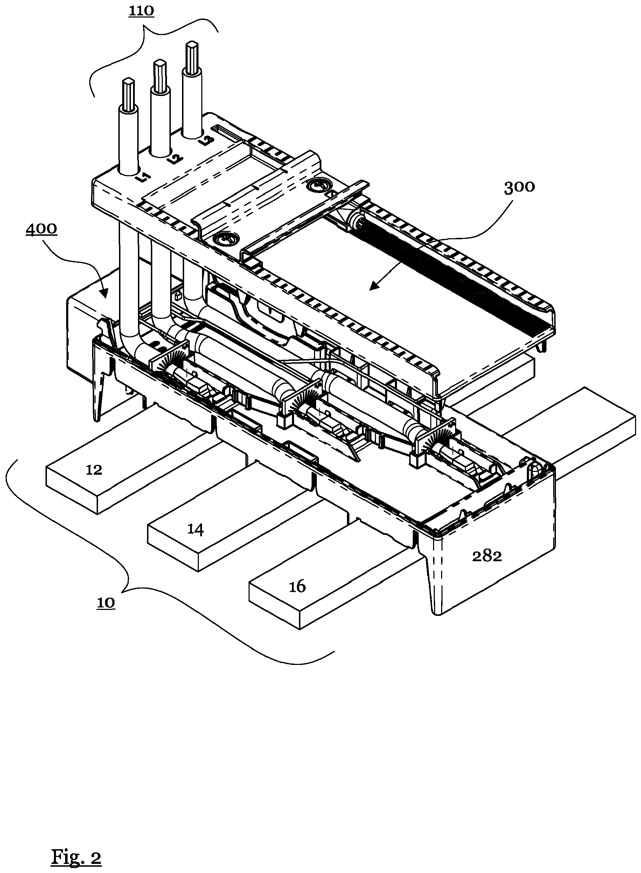

Fig. 2 zeigt die in Fig. 1 gezeigte Ausführungsform in einer teilweisen Explosionsdarstellung, bei der das Oberdeckelement 300 teilweise vertikal nach oben verschoben dargestellt ist, so dass die Sicht auf das Unterdeckelement 200 freigegeben ist.

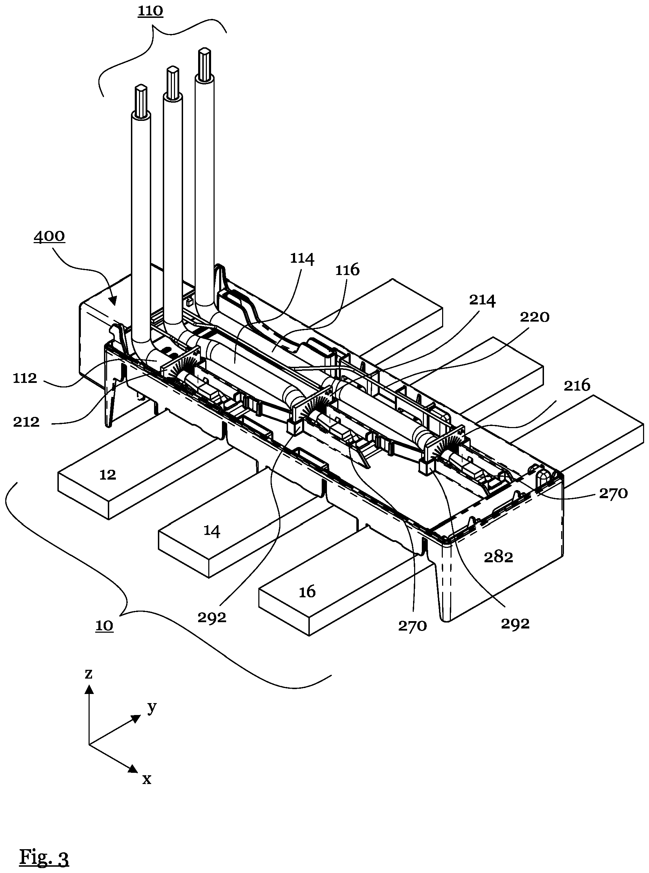

Fig. 3 zeigt die in den Fig. 1 und 2 gezeigte Ausführungsform, bei denen das Oberdeckelement vollständig entfernt worden ist.

Fig. 3 zeigt den Verlauf der Kontaktleitungen 112, 114, 116, sowie zumindest teilweise die Kontaktvorrichtungen 270, siehe hierzu auch Fig. 4.

Ferner umfasst der Sammelschienenadapter 100 auch eine Strommessvorrichtung, die bei dieser Ausführungsform durch insgesamt Rogowskispulen 212, 214, 216 realisiert sind. Wie in Fig. 3 gut ersichtlich, sind die Rogowskispulen 212, 214, 216 bei dieser Ausführungsform senkrecht angeordnet, also im Wesentlichen parallel zu den Stirnflächen 282 (284, siehe Fig. 4) oder auch senkrecht zu einer x-y-Ebene, die von den Sammelschienen des Sammelschienensystems gebildet wird. Die Rogowskispulen bzw. die plattenförmigen Bauteile erstrecken sich daher in einer y-z-Richtung, in der sich auch die Ebene der Stirnseiten 282 (284, siehe Fig. 4) des Unterdeckelements erstrecken.

Die plattenförmigen Rogowskispulen 212, 214, 216 sind in schlitzförmigen Aufnahmetaschen 292 angeordnet, die sich ebenfalls senkrecht bzw. in der y-z-Richtung erstrecken und teilweise in einen zugehörigen Fuß des Unterdeckelements 200 hineinragen, was in Fig. 4 noch besser ersichtlich ist.

Die Rogowskispulen 212, 214, 216 bzw. die entsprechenden Bauteile haben eine im Wesentlichen zentral angeordnete Öffnung, durch die die Kontaktleitungen 112, 114, 116 geführt werden, so dass die Strommessung für jede Phase erfolgen kann.

Die Rogowskispulen 212, 214, 216 sind mittels Leitungen 220 mit der elektronischen Auswerteeinheit 400 verbunden, so dass die Ergebnisse der Strommessung dort empfangen, verarbeitet und/oder weitergeleitet werden können, beispielsweise über ein Buss-System.

Fig. 4 zeigt eine Teil-Querschnittsansicht durch einige Bauteile der in den Fig. 1 bis 3 gezeigten Ausführungsform. Fig. 4 verdeutlicht nochmals die Anordnung der Rogowskispulen, insbesondere der Rogowskispule 212, die eine zentrale Öffnung 213 aufweist, durch die die Kontaktleitung 112 geführt ist. Wie ebenfalls in Fig. 4 deutlich ersichtlich ist, ist die Kontaktleitung 112 im Bereich der Rogowskispule 212 abisoliert.

Fig. 4 zeigt auch die schlitzförmige Aufnahmetasche 292 zur Aufnahme der Rogowskispule 212, wobei sich die Aufnahmetasche 292 teilweise in den Bereich des Fußes 290 erstreckt. Auch die Rogowskispule 212 bzw. das entsprechende Bauteil erstreckt sich daher teilweise, bei der hier gezeigten Ausführungsform über etwa die Hälfte seiner Kantenlänge, in den Bereich des Fußes 290 des Unterdeckelements 200.

Wie daher gut in Fig. 4 ersichtlich ist, sind die Rogowskispulen 212 (214, 216, siehe Fig. 3) daher besonders platzsparend und effektiv angeordnet, so dass die Bauhöhe des Unterdeckelements im Vergleich zu Sammelschienenadaptern ohne Strommessung nicht erhöht werden braucht. Gleichzeitig ragen die Rogowskispulen nicht über eine Oberkante des Unterdeckelements 200 hinaus, also über eine Kante des Unterdeckelements 200, die in Richtung auf das Oberdeckelement ausgerichtet ist.

Wie ebenfalls in Fig. 4 ersichtlich ist, ist die elektronische Auswerteeinheit 400 an einer Stirnfläche 284 des Unterdeckelements 200 angeordnet, wobei die Abmessungen so gewählt sind, dass auch durch die Auswerteeinheit die Bauhöhe des Sammelschienenadapters in keiner Weise vergrößert wird.

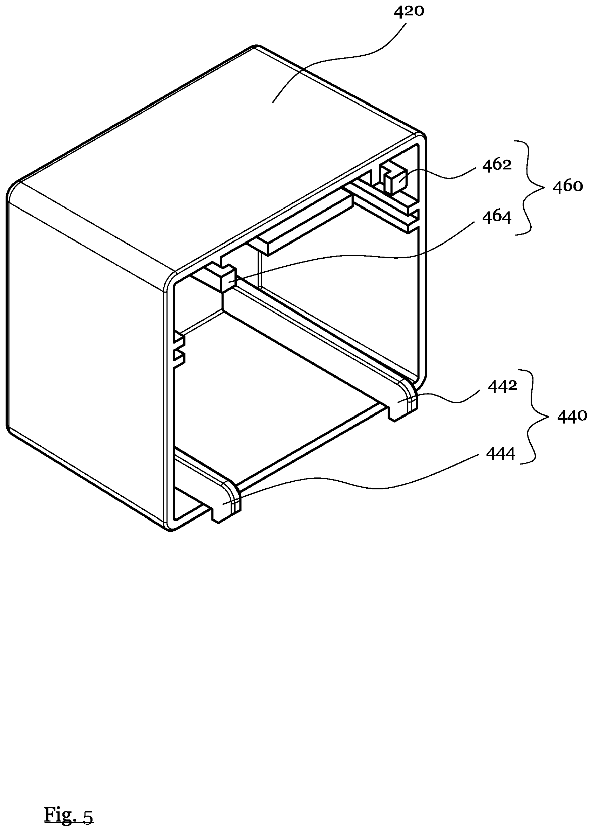

Fig. 5 zeigt eine Ausführungsform eines Gehäuses 420 der elektronischen Auswerteeinheit, wie sie in der oben genannten Ausführungsform verwendet werden kann.

Wie in Fig. 5 deutlich ersichtlich, umfasst das Gehäuse 420 untere Hakenelemente 442, 444, in ihrer Gesamtheit mit dem Bezugszeichen 440 versehen, und obere Hakenelemente 462, 464, in ihrer Gesamtheit mit dem Bezugszeichen 460 versehen. Diese Hakenelemente 440, 460 werden in den entsprechenden Öffnungen des Unterdeckelements eingesetzt, so dass die elektronische Auswerteeinheit bzw. das Gehäuse 420 sicher mit dem Sammelschienenadapter, insbesondere dem Unterdeckelement, verbunden werden kann. Die unteren Hakenelemente 440 sind dabei nach unten, also in z-Richtung, gebogen, während die oberen Hakenelemente 460 nach innen, also in y-Richtung, gebogen sind, so dass eine sichere Positionierung in alle Richtungen sichergestellt ist.

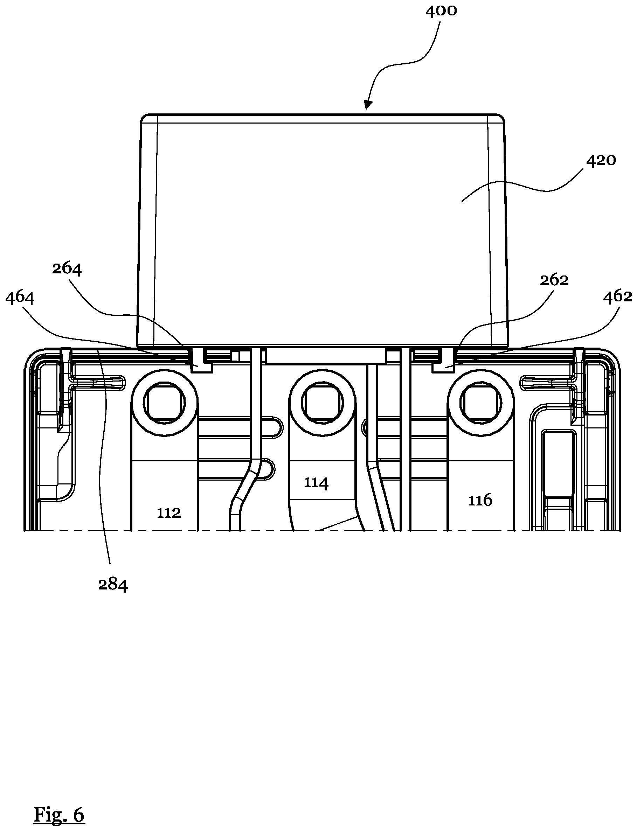

Fig. 6 zeigt eine teilweise Draufsicht auf eine Ausführungsform eines erfindungsgemäßen Sammelschienenadapters in dem Bereich, in dem die elektronische Auswerteeinheit 400 angeordnet ist.

Wie in Fig. 6 ersichtlich ist, liegen die oberen Hakenelemente 462 und 464 in zugeordneten Öffnungen 262, 264, die in der Stirnwand 284 des Unterdeckelements vorgesehen sind. Die Öffnungen 262 und 264 sind nach oben offen, so dass die Hakenelemente 462, 464 einfach eingesetzt werden können.

Sobald das Oberdeckelement (in Fig. 6 nicht gezeigt) auf das Unterdeckelement 200 aufgesetzt wird, werden die Hakenelemente 462 und 464 in den zugehörigen Öffnungen 262, 264 gehalten und verriegelt, so dass die Auswerteeinheit 400 sicher an dem Sammelschienenadapter befestigt ist.

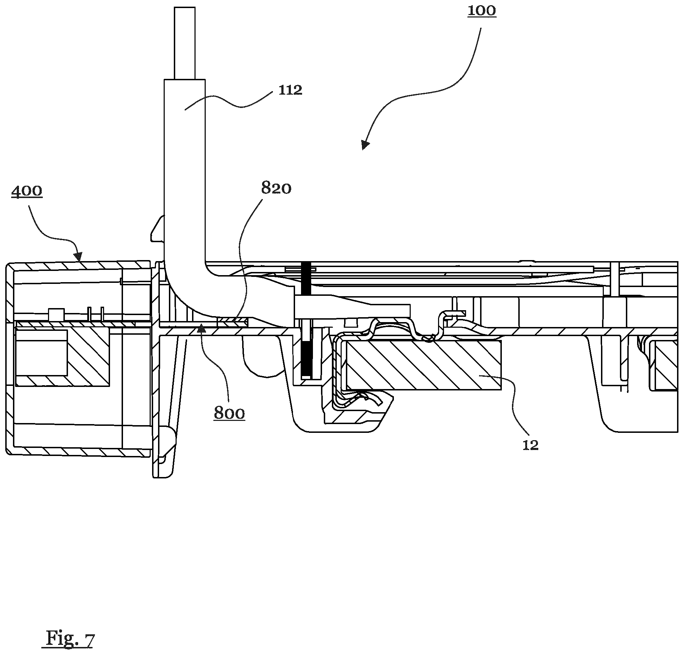

Fig. 7 zeigt eine Teil-Querschnittsansicht einiger Elemente einer weiteren Ausführungsform eines erfindungsgemäßen Sammelschienenadapters. Diese in Fig. 7 gezeigte Ausführungsform ist der in Fig. 4 gezeigten Ausführungsform sehr ähnlich, so dass insbesondere auf die Beschreibung der in den Figuren 3 und 4 gezeigten Ausführungsform verwiesen wird, um Wiederholungen zu vermeiden.

Im Unterschied zu der in den Fig. 3 und 4 gezeigten Ausführungsform umfasst die in Fig. 7 gezeigte Ausführungsform des erfindungsgemäßen Sammelschienenadapters 100 zusätzlich ein Messelement, das mittels einer kapazitiven Kopplung Messungen für jede der Phasen durchführen kann.

Wie in Fig. 7 ersichtlich umfasst diese Ausführungsform des Sammelschienenadapters 100 ein Messelement 800, die sich zum Teil in dem Sammelschienenadapter 100 selbst und zum Teil in die Auswerteeinheit 400 erstreckt. Das Messelement 800 umfasst hierzu mehrere kapazitive Elemente 820, die so angeordnet sind, dass sie in Betriebsstellung direkt an die Kontaktleitungen (112, 114, 116, s. beispielsweise Fig. 3 angrenzen, wobei in Fig. 7 nur eine der Kontaktleitungen, nämlich die Kontaktleitung 112 sichtbar ist).

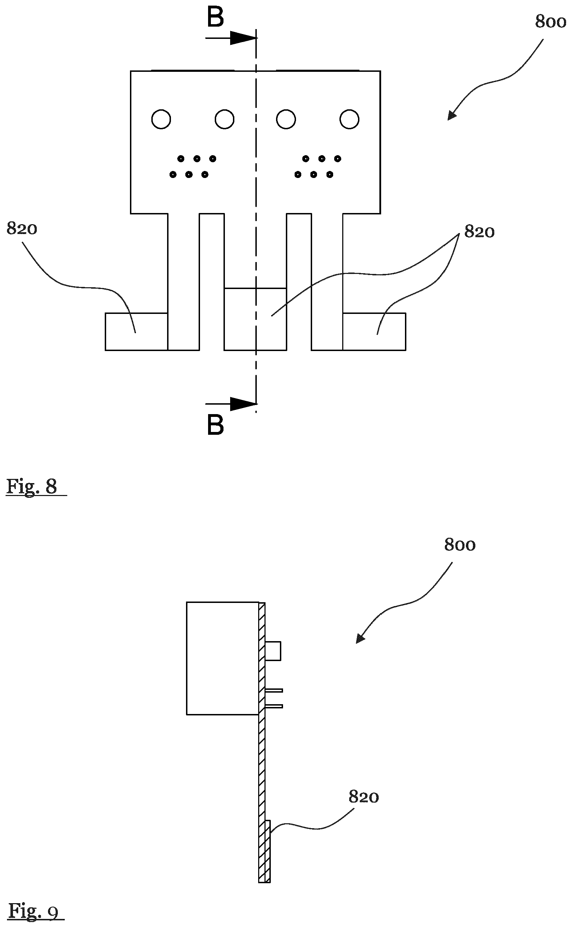

Fig. 8 zeigt eine Draufsicht auf das Messelement 800, und in Fig. 8 ist sehr gut ersichtlich, dass das Messelement 800 insgesamt drei kapazitive Elemente 820, für jede der drei Phasen, umfasst.

Das kapazitive Element 820, das in Fig. 7 zu sehen ist, entspricht dem in Fig. 8 links dargestellten kapazitiven Element 820.

Fig. 9 schließlich zeigt einen Querschnitt durch ein kapazitives Modul 800 entlang der Linie B-B in Fig. 8, in dem ebenfalls das kapazitive Element 820 gut sichtbar dargestellt ist. Dieses kapazitive Element ermöglicht eine weitere und detailliertere Überwachung des Betriebszustandes des Gesamtsystems.

## Patentansprüche

1. Unterdeckelement (200) für einen Sammelschienenadapter (100), wobei der Sammelschienenadapter zum Anschluss an ein mehrphasiges Sammelschienensystem (10), bevorzugt an ein dreiphasiges Sammelschienensystem (10) mit drei Sammelschienen (12, 14, 16), ausgebildet ist, wobei das Unterdeckelement (200) ausgebildet ist, um eine elektrische Verbindung mit den Sammelschienen (12, 14, 16) des Sammelschienensystems (10) herzustellen, wobei der Sammelschienenadapter (100) mindestens zwei Kontaktvorrichtungen (270), jeweils zum Anschluss an eine Sammelschiene (12, 14, 16), und mindestens zwei Kontaktleitungen (112, 114, 116) für eine elektrische Verbindung zu einem elektrischen Gerät umfasst, wobei jede Kontaktleitung (112, 114, 116) elektrisch an eine entsprechende Kontaktvorrichtung (270) angeschlossen ist und wobei das Unterdeckelement (200) ausgebildet ist, um die Kontaktvorrichtungen (270) an dem Unterdeckelement (200) anzuordnen,
wobei das Unterdeckelement (200) mindestens zwei Fußelemente (290) zur Befestigung des Unterdeckelements (200) an Sammelschienen (12, 14, 16; 10) umfasst,
**dadurch gekennzeichnet, dass**:
das Unterdeckelement (200) mindestens zwei Aufnahmetaschen (292, 292'), bevorzugt schlitzförmige Aufnahmetaschen (292), jeweils für eine entsprechende Strommessvorrichtung (212, 214, 216, 212', 214', 216') von mindestens zwei Strommessvorrichtungen (212, 214, 216, 212', 214', 216') umfasst, wobei die mindestens zwei Strommessvorrichtungen so ausgebildet sind, dass in dem Sammelschienenadapter eine Strommessung für jede Phase des Sammelschienenadapters erfolgen kann, wobei die Aufnahmetaschen (292) jeweils eine Ebene definieren, die, wenn das Unterdeckelement am Sammelschienensystem montiert ist, senkrecht oder im Wesentlichen senkrecht zu einer Ebene verläuft, die von den Sammelschienen (12, 14, 16; 10) gebildet wird, und wobei sich jede der Aufnahmetaschen (292) zumindest teilweise in ein Fußelement (290) erstreckt.

2. Sammelschienenadapter zum Anschluss an ein mehrphasiges Sammelschienensystem (10), bevorzugt an ein dreiphasiges Sammelschienensystem (10) mit drei Sammelschienen (12, 14, 16),
wobei ein Gehäuse des Sammelschienenadapters ein Oberdeckelement (300) und ein Unterdeckelement (200) nach Anspruch 1 umfasst und wobei das Oberdeckelement (300) ausgebildet ist, um elektrische Geräte daran zu befestigen, und wobei das Unterdeckelement (200) ausgebildet ist, um eine elektrische Verbindung mit den Sammelschienen (12, 14, 16) des Sammelschienensystems (10) herzustellen,
wobei der Sammelschienenadapter (100) mindestens zwei Kontaktvorrichtungen (270), jeweils zum Anschluss an eine Sammelschiene (12, 14, 16), und mindestens zwei Kontaktleitungen (112, 114, 116) für eine elektrische Verbindung zu einem elektrischen Gerät umfasst, wobei jede Kontaktleitung (112, 114, 116) elektrisch an eine entsprechende Kontaktvorrichtung (270) angeschlossen ist und wobei die Kontaktvorrichtungen (270) an dem Unterdeckelement (200) angeordnet sind,
wobei der Sammelschienenadapter (100) mindestens zwei Strommessvorrichtungen (212, 214, 216, 212', 214', 216') umfasst, die jeweils in eine entsprechende Aufnahmetasche (292, 292') des Unterdeckelements (200) eingesetzt sind und die so ausgebildet ist, dass in dem Sammelschienenadapter eine Strommessung für jede Phase des Sammelschienenadapters erfolgen kann.

3. Sammelschienenadapter nach Anspruch 2, **dadurch gekennzeichnet, dass** die mindestens zwei Stromessvorrichtungen mindestens eine Rogowskispule (212, 214, 216, 212', 214', 216') umfassen, bevorzugt eine Rogowskispule pro Phase.

4. Sammelschienenadapter nach Anspruch 3, **dadurch gekennzeichnet, dass** mindestens eine Rogowskispule (212, 214, 216), bevorzugt alle Rogowskispulen, so in den Aufnahmetaschen (292, 292') des Unterdeckelements (200) angeordnet und befestigt sind, dass eine Ebene, in der die Spulenwicklungen der Rogowskispule (212, 214, 216) liegen, senkrecht oder im Wesentlichen senkrecht zu einer Ebene verläuft, die von den Sammelschienen (12, 14, 16) des Sammelschienensystems (100) gebildet wird.

5. Sammelschienenadapter nach einem der Ansprüche 2 bis 4, **dadurch gekennzeichnet, dass** die Aufnahmetaschen (290) in Form von Sacklöchern ausgebildet sind.

6. Sammelschienenadapter nach einem der Ansprüche 3 bis 5, **dadurch gekennzeichnet, dass** die Rogowskispulen (212, 214, 216, 212', 214', 216') als Bauteil realisiert sind, das eine Plattenform, bevorzugt eine rechteckige Plattenform, insbesondere eine quadratische Plattenform, aufweist.

7. Sammelschienenadapter nach einem der Ansprüche 2 bis 6, **dadurch gekennzeichnet, dass** er eine elektronische Auswerteeinheit (400) umfasst.

8. Sammelschienenadapter nach Anspruch 7, **dadurch gekennzeichnet, dass** die elektronische Auswerteeinheit (400) ein Gehäuse (420) umfasst, das an einer Stirnfläche des Sammelschienenadapters (100), insbesondere an einer Stirnfläche (284) des Unterdeckelements (200) des Sammelschienenadapters (100), befestigt werden kann, wobei das Gehäuse (420) bevorzugt ein oder mehrere Hakenelemente (442, 444, 440; 462, 464, 460) umfasst, die in zugehörige Öffnungen in einer Stirnfläche (284) des Sammelschienenadapters, insbesondere zugehörige Öffnungen in einer Stirnfläche (284) des Unterdeckelements (200) des Sammelschienenadapters (100), eingesetzt werden können.

9. Sammelschienenadapter nach Anspruch 7 oder 8, **dadurch gekennzeichnet, dass** die elektronische Auswerteeinheit (400) an einer Stirnfläche (284) des Unterdeckelements (200) des Sammelschienenadapters befestigt werden kann, wobei der Sammelschienenadapter so ausgebildet ist, dass die elektronische Auswerteeinheit (400) durch das Oberdeckelement (300) an der Stirnfläche (284) des Unterdeckelements verriegelt wird, wenn sich Unterdeckelement (200) und Oberdeckelement (300) in ihrer Betriebsstellung befinden.

10. Sammelschienenadapter nach einem der Ansprüche 3 bis 9, **dadurch gekennzeichnet, dass** die Kontaktleitungen (112, 114, 116, 100) im Bereich der Rogowskispulen (212, 214, 216, 212', 214', 216') abisoliert sind.

11. Sammelschienenadapter nach einem der Ansprüche 7 bis 10, **dadurch gekennzeichnet, dass** jede der Strommessvorrichtung, insbesondere jede der Rogowskispulen (212, 214, 216, 212', 214', 216'), mittels elektrischer Leitungen (220) mit der elektronischen Auswerteeinheit (400) verbunden sind.

12. Sammelschienenadapter nach einem der Ansprüche 7 bis 11, **dadurch gekennzeichnet, dass** die elektronische Auswerteeinheit (400) mindestens eine RJ-Buchse (470) zum Anschluss an eine Busanbindung umfasst.

## Claims

1. A lower deck element (200) for a busbar adapter (100), wherein the busbar adapter is designed for connection to a polyphase busbar system (10), preferably to a three-phase busbar system (10) having three busbars (12, 14, 16), wherein the lower deck element (200) is designed to establish an electrical connection to the busbars (12, 14, 16) of the busbar system (10), wherein the busbar adapter (100) comprises at least two contact devices (270), each for connection to a busbar (12, 14, 16), and at least two contact lines (112, 114, 116) for an electrical connection to an electrical device, wherein each contact line (112, 114, 116) is connected electrically to a corresponding contact device (270), and wherein the lower deck element (200) is designed to arrange the contact devices (270) on the lower deck element (200),
wherein the lower deck element (200) comprises at least two foot elements (290) for fastening the lower deck element (200) to busbars (12, 14, 16; 10),
**characterised in that**:
the lower deck element (200) comprises at least two receiving pockets (292, 292'), preferably slot-shaped receiving pockets (292), each for a corresponding current-measuring device (212, 214, 216, 212', 214', 216') of at least two current-measuring devices (212, 214, 216, 212', 214', 216'), wherein the at least two current-measuring devices are designed such that a current measurement for each phase of the busbar adapter can be carried out in the busbar adapter, wherein the receiving pockets (292) each define a plane which, when the lower deck element is mounted on the busbar system, runs perpendicularly or substantially perpendicularly to a plane which is formed by the busbars (12, 14, 16; 10), and wherein each of the receiving pockets (292) extends at least partially into a foot element (290).

2. A busbar adapter for connection to a polyphase busbar system (10), preferably to a three-phase busbar system (10) having three busbars (12, 14, 16),
wherein a housing of the busbar adapter comprises a top covering element (300) and a lower deck element (200) according to Claim 1, and wherein the top covering element (300) is designed to fasten electrical devices thereto, and wherein the lower deck element (200) is designed to establish an electrical connection to the busbars (12, 14, 16) of the busbar system (10),
wherein the busbar adapter (100) comprises at least two contact devices (270), each for connection to one busbar (12, 14, 16), and at least two contact lines (112, 114, 116) for an electrical connection to an electrical device, wherein each contact line (112, 114, 116) is electrically connected to a corresponding contact device (270), and wherein the contact devices (270) are arranged on the lower deck element (200),
wherein the busbar adapter (100) comprises at least two current-measuring devices (212, 214, 216, 212', 214', 216'), which are each inserted into a corresponding receiving pocket (292, 292') of the lower deck element (200) and designed such that a current measurement for each phase of the busbar adapter can be carried out in the busbar adapter.

3. The busbar adapter according to Claim 2, **characterised in that** the at least two current-measuring devices comprise at least one Rogowski coil (212, 214, 216, 212', 214', 216'), preferably one Rogowski coil per phase.

4. The busbar adapter according to Claim 3, **characterised in that** at least one Rogowski coil (212, 214, 216), preferably all the Rogowski coils, are arranged and fastened in the receiving pockets (292, 292') of the lower deck element (200) such that a plane in which the coil windings of the Rogowski coil (212, 214, 216) lie runs perpendicularly or substantially perpendicularly to a plane which is formed by the busbars (12, 14, 16) of the busbar system (100).

5. The busbar adapter according to one of Claims 2 to 4, **characterised in that** the receiving pockets (290) are in the form of blind holes.

6. The busbar adapter according to one of Claims 3 to 5, **characterised in that** the Rogowski coils (212, 214, 216, 212', 214', 216') are implemented as a component which has a plate shape, preferably a rectangular plate shape, in particular a square plate shape.

7. The busbar adapter according to one of Claims 2 to 6, **characterised in that** it comprises an electronic evaluation unit (400).

8. The busbar adapter according to Claim 7, **characterised in that** the electronic evaluation unit (400) comprises a housing (420) which can be fastened to an end face of the busbar adapter (100), in particular to an end face (284) of the lower deck element (200) of the busbar adapter (100), wherein the housing (420) preferably comprises one or more hook elements (442, 444, 440; 462, 464, 460), which can be inserted into associated openings in an end face (284) of the busbar adapter, in particular associated openings in an end face (284) of the lower deck element (200) of the busbar adapter (100) .

9. The busbar adapter according to Claim 7 or 8, **characterised in that** the electronic evaluation unit (400) can be fastened to an end face (284) of the lower deck element (200) of the busbar adapter, wherein the busbar adapter is designed such that the electronic evaluation unit (400) is locked by the top covering element (300) on the end face (284) of the lower deck element when the lower deck element (200) and the top covering element (300) are in their operating position.

10. The busbar adapter according to one of Claims 3 to 9, **characterised in that** the contact lines (112, 114, 116, 100) are stripped of insulation in the region of the Rogowski coils (212, 214, 216, 212', 214', 216').

11. The busbar adapter according to one of Claims 7 to 10, **characterised in that** each of the current-measuring devices, in particular each of the Rogowski coils (212, 214, 216, 212', 214', 216'), are connected to the electronic evaluation unit (400) by means of electrical lines (220).

12. The busbar adapter according to one of Claims 7 to 11, **characterised in that** the electronic evaluation unit (400) comprises at least one RJ socket (470) for connection to a bus link.

## Revendications

1. Élément d'étage inférieur (200) pour un adaptateur de rail collecteur (100), dans lequel l'adaptateur de rail collecteur est conçu pour le raccordement à un système de rail collecteur multiphasé (10), de préférence à un système de rail collecteur triphasé (10) avec trois rails collecteurs (12, 14, 16), dans lequel l'élément d'étage inférieur (200) est conçu pour établir une liaison électrique avec les rails collecteurs (12, 14, 16) du système de rail collecteur (10), dans lequel l'adaptateur de rail collecteur (100) comprend au moins deux dispositifs de contact (270), respectivement pour le raccordement à un rail collecteur (12, 14, 16), et au moins deux lignes de contact (112, 114, 116) pour une liaison électrique avec un appareil électrique, dans lequel chaque ligne de contact (112, 114, 116) est raccordée électriquement à un dispositif de contact (270) correspondant et dans lequel l'élément d'étage inférieur (200) est conçu afin de disposer les dispositifs de contact (270) sur l'élément d'étage inférieur (200),
dans lequel l'élément d'étage inférieur (200) comprend au moins deux éléments de pied (290) pour la fixation de l'élément d'étage inférieur (200) à des rails collecteurs (12, 14, 16 ; 10),
**caractérisé en ce que** :
l'élément d'étage inférieur (200) comprend au moins deux compartiments de logement (292, 292'), de préférence des compartiments de logements en forme de fentes (292), respectivement pour un dispositif de mesure de courant (212, 214, 216, 212', 214', 216') correspondant, constitué d'au moins deux dispositifs de mesure de courant (212, 214, 216, 212', 214', 216'), dans lequel les au moins deux dispositifs de mesure de courant sont conçus de sorte que, dans l'adaptateur de rail collecteur, une mesure de courant peut être effectuée pour chaque phase de l'adaptateur de rail collecteur, dans lequel les compartiments de logement (292) définissent chacun un plan qui, lorsque l'élément d'étage inférieur est monté sur le système de rail collecteur, s'étend perpendiculairement ou globalement perpendiculairement par rapport à un plan, qui est formé par les rails collecteurs (12, 14, 16 ; 10) et dans lequel chacun des compartiments de logement (292) s'étend au moins partiellement dans un élément de pied (290).

2. Adaptateur de rail collecteur pour le raccordement à un système de rail collecteur multiphasé (10), de préférence à un système de rail collecteur triphasé (10) avec trois rails collecteurs (12, 14, 16),
dans lequel un boîtier de l'adaptateur de rail collecteur comprend un élément d'étage supérieur (300) et un élément d'étage inférieur (200) selon la revendication 1 et dans lequel l'élément d'étage supérieur (300) est conçu pour y fixer des appareils électriques, et dans lequel l'élément d'étage inférieur (200) est conçu pour établir une liaison électrique avec les rails collecteurs (12, 14, 16) du système de rail collecteur (10),
dans lequel l'adaptateur de rail collecteur (100) comprend au moins deux dispositifs de contact (270), respectivement pour le raccordement à un rail collecteur (12, 14, 16) et au moins deux lignes de contact (112, 114, 116) pour une liaison électrique avec un appareil électrique, dans lequel chaque ligne de contact (112, 114, 116) est raccordée électriquement à un dispositif de contact (270) correspondant et dans lequel les dispositifs de contact (270) sont disposés sur l'élément d'étage inférieur (200),
dans lequel l'adaptateur de rail collecteur (100) comprend au moins deux dispositifs de mesure de courant (212, 214, 216, 212', 214', 216') qui sont insérés chacun dans un compartiment de logement (292, 292') correspondant de l'élément d'étage inférieur (200) et qui sont conçus de sorte que, dans l'adaptateur de rail collecteur, une mesure de courant peut être effectuée pour chaque phase de l'adaptateur de rail collecteur.

3. Adaptateur de rail collecteur selon la revendication 2, **caractérisé en ce que** les au moins deux dispositifs de mesure de courant comprennent au moins une bobine de Rogowski (212, 214, 216, 212', 214', 216'), de préférence une bobine de Rogowski par phase.

4. Adaptateur de rail collecteur selon la revendication 3, **caractérisé en ce qu'**au moins une bobine de Rogowski (212, 214, 216), de préférence toutes les bobines de Rogowski, sont disposées et fixées dans les compartiments de logement (292, 292') de l'élément d'étage inférieur (200) de sorte qu'un plan, dans lequel se trouvent les spires de la bobine de Rogowski (212, 214, 216), s'étend perpendiculairement ou globalement perpendiculairement à un plan qui est formé par les rails collecteurs (12, 14, 16) du système de rail collecteur (100).

5. Adaptateur de rail collecteur selon l'une des revendications 2 à 4, **caractérisé en ce que** les compartiments de logement (290) présentent la forme de trous borgnes.

6. Adaptateur de rail collecteur selon l'une des revendications 3 à 5, **caractérisé en ce que** les bobines de Rogowski (212, 214, 216, 212', 214', 216') sont réalisées comme un composant qui présente une forme de plaque, de préférence une forme de plaque rectangulaire, plus particulièrement une forme de plaque carrée.

7. Adaptateur de rail collecteur selon l'une des revendications 2 à 6, **caractérisé en ce qu'**il comprend une unité d'analyse électronique (400).

8. Adaptateur de rail collecteur selon la revendication 7, **caractérisé en ce que** l'unité d'analyse électronique (400) comprend un boîtier (420) qui peut être fixé à une face frontale de l'adaptateur de rail collecteur (100), plus particulièrement à une face frontale (284) de l'élément d'étage inférieur (200) de l'adaptateur de rail collecteur (100), dans lequel le boîtier (420) comprend de préférence un ou plusieurs éléments de type crochets (442, 444, 440 ; 462, 464, 460) qui peuvent être insérés dans des ouvertures correspondantes dans une face frontale (284) de l'adaptateur de rail collecteur, plus particulièrement des ouvertures correspondantes dans une face frontale (284) de l'élément d'étage inférieur (200) de l'adaptateur de rail collecteur (100).

9. Adaptateur de rail collecteur selon la revendication 7 ou 8, **caractérisé en ce que** l'unité d'analyse électronique (400) peut être fixée à une face frontale (284) de l'élément d'étage inférieur (200) de l'adaptateur de rail collecteur, dans lequel l'adaptateur de rail collecteur est conçue de sorte que l'unité d'analyse électronique (400) est verrouillée par l'élément d'étage supérieur (300) à la face frontale (284) de l'élément d'étage inférieur lorsque l'élément d'étage inférieur (200) et l'élément d'étage supérieur (300) se trouvent dans leur position de fonctionnement.

10. Adaptateur de rail collecteur selon l'une des revendications 3 à 9, **caractérisé en ce que** les lignes de contact (112, 114, 116, 100) sont isolées au niveau des bobines de Rogowski (212, 214, 216, 212', 214', 216').

11. Adaptateur de rail collecteur selon l'une des revendications 7 à 10, **caractérisé en ce que** chacun des dispositifs de mesure de courant, plus particulièrement chacune des bobines de Rogowski (212, 214, 216, 212', 214', 216'), sont reliés au moyen de lignes électriques (220), avec l'unité d'analyse électronique (400).

12. Adaptateur de rail collecteur selon l'une des revendications 7 à 11, **caractérisé en ce que** l'unité d'analyse électronique (400) comprend au moins une prise RJ (470) pour le raccordement à une liaison par bus.
